# EUROPEAN PATENT SPECIFICATION

(11) **EP 0 672 500 B1**
(45) Date of publication and mention of the grant of the patent: **19.12.2001**
(21) Application number: 95103487.5
(22) Date of filing: 10.03.1995
(51) Int. Cl.: B24C 1/00, B24C 1/04, B44C 1/22

(54) **Polymeric mask for sandblasting and method for its use**
Polymere Maske für Sandstrahlen und Verfahren zu deren Anwendung
Masque polymère pour le sablage et procédé pour son utilisation

(30) Priority: 14.03.1994 JP 6900894
(43) Date of publication of application: 20.09.1995
(73) Proprietor: AICELLO CHEMICAL CO. LTD., Toyohashi-shi Aichi-ken (JP)
(72) Inventor: Suzuki, Ikuo, Toyohashi-shi, Aichi-ken (JP)
(74) Representative: Boeters, Hans Dietrich, Dr.

(56) References cited:
- EP-A- 0 130 559
- EP-A- 0 506 959
- GB-A- 2 257 935
- US-A- 4 764 449
- DATABASE WPI Week 8750 Derwent Publications Ltd., London, GB; AN 87-349116 & DD-A-248 133 (VEB FLACHGLAS TORGA) , 29 July 1987
- DATABASE WPI Week 9231 Derwent Publications Ltd., London, GB; AN 92-255743 & JP-A-04 173 845 (DAIICHI KOGYO SEIYAKU CO LTD) , 22 June 1992
- DATABASE WPI Week 9317 Derwent Publications Ltd., London, GB; AN 93-140466 & JP-A-05 078 541 (SEKISUI CHEM IND CO LTD) , 30 March 1993

## Description

### BACKGROUND OF THE INVENTION

### Field of the Invention

The present invention relates to a sandblast resist ink and resist ink for sandblasting, respectively, which is an aqueous composition and to a method of sandblasting using the composition (see for example DD-A-248 133).

### Description of the Prior Art

Pattern forming techniques for producing a relief of photographic images, patterns, letters, or characters on the surface of glasses, stones, ceramics, metals, plastics, woods, or the like by mechanical or chemical processing of these surfaces are widely used applied in the production of display boards, ornamental articles, or artistic works.

Conventional surface processing methods for producing relief images on the surfaces of these materials are broadly classified into (a) a method of using no resist mask and (b) a method of using resist mask. In the method using no resist mask (a), a relief is produced by manually engraving the surfaces with a cutter or mechanically engraving using a cutting machine. In the method using a resist mask (b), the resist mask is formed on the surface of the material to be processed, followed by blowing air pressured with metal powder, such as aluminum oxide, to the surface to abrase and engrave the part of the surface where no resist mask has been formed, thereby producing a relief. This method has been widely applied in recent years because of simplicity of the treatment and capability of producing relief images during a short period though it requires a blasting machine.

As a means for forming resist masks for sandblast in the method (b), the screen printing method has been conventionally applied. In the screen printing method, a resist mask of the image is produced directly onto the surface to be processed by screen printing with a sandblast resist ink or produced by transferring a so-called mask, which has been made by screen printing the image on an easily released substrate to the surface to be processed. The screen printing method is efficient and economical when a large number of the articles with the same image are to be processed. A major component of conventional screen printing resist ink used for the production of sandblast resist mask is a solution of a polyvinyl chloride resin dissolved in an organic solvent such as toluene, butyl acetate, or butyl cellosolve. Because the strength of the film produced by printing with the said resist ink and drying at room temperature is insufficient, it is necessary to treat the film at a high temperature as an additional step.

Several types of resist inks for improving adhesion strength and film strength have been used. For example, reactive-type inks comprising a curing agent, photocrosslinkable inks, i.e. photosensitive inks, which are crosslinked after printing by irradiation, and the like.

However, because all these types of resist ink for screen printing consist of an organic solvent such as toluene, acetone, or butyl acetate, screen printing plates and instruments used in the screen printing must be washed to be clean with individual organic solvent. In addition, it is not a simple task to remove the resist mask after sandblasting. Because the resist mask is strongly adhered to the surfaces of the material to be processed, organic solvents must be used for removing these masks.

The use of a solvent is not only uneconomical, but also contaminates the working environment. Resist inks insoluble in an alkaline aqueous solution have been proposed in order to overcome these problems. Such resist inks are not yet satisfactory. Because the inks are made insoluble in the alkaline aqueous solution after curing, the use of an organic solvent is indispensable for removing resist masks.

### SUMMARY OF THE INVENTION

Accordingly an object of the present invention is to provide a sandblast resist ink which does not require the use of solvents and a sandblast processing method by using the resist ink.

The sandblast resist ink of the present invention is an aqueous composition comprising an aqueous dispersion of a polymer having a minimum film-forming temperature of 10°C or less and a water-soluble polymer. A resist mask can be produced by using the sandblast resist ink of the present invention without using any organic solvents in all steps (e.g. the resist mask forming step and the resist mask removing step) of sandblast processing for producing a relief of photographic images, patterns, letters, or characters on the surface of glass, stones, ceramics, metals, plastics, woods, and the like.

The sandblast resist ink of the present invention is a composition comprising an aqueous dispersion of a polymer having a minimum film-forming temperature of 10°C or less as a major component and a water-soluble polymer as an agent for improving film-forming properties. The ink is used as a sandblast resist ink for producing dry films whose degree of swelling is in the range of 0.1-1.5 in water at 20°C.

The sandblast resist ink of the present invention exhibits surprising advantages as compared with the conventional organic solvent-type sandblast resist inks.

The advantages of the invention will become more readily apparent through the following description.

### DETAILED DESCRIPTION OF THE INVENTION AND PREFERRED EMBODIMENTS

The present inventors have conducted extensive studies in order to overcome the drawbacks in the conventional resist mask inks for sandblast processing by using solvents, and found that an aqueous composition comprising an aqueous dispersion of a polymer having a minimum film-forming temperature of 10°C or less as a major component and a water-soluble polymer as an agent for film-forming can produce dry films whose degree of swelling is in the range of 0.1-1.5 in water at 20°C.

The present inventors have further found that a resist mask can be produced by using the sandblast resist ink of the present invention without use of any organic solvents in all steps, such as the resist mask forming step and the resist mask removing step, of sandblast processing for producing a relief of photographic images, patterns, letters, or characters on the surface of glass, stones, ceramics, metals, plastics, woods, and the like. That is to say, the present invention provides an aqueous sandblast resist ink, especially suitable for use in screen printing, which can produce a resist mask exhibiting sufficient adhesion to any optional surfaces to be processed by sandblasting, such as glass, metals, or plastics, and having sufficient strength, for sandblast processing without using any organic solvents in all steps, from formation of the resist mask to removal thereof after the sandblast treatment.

The aqueous composition for preparing the sandblast resist ink of the present invention comprises, (A) an aqueous dispersion of at least one polymer selected from the group consisting of polyvinyl acetate resins, ethylene-vinyl acetate copolymers, vinyl acetate-acrylate copolymers, acrylic copolymers, and polyurethane copolymers, and (B) at least one water-soluble polymer selected from the group consisting of arginic acid derivatives, sodium carboxymethyl cellulose, methylcellulose, polyvinyl alcohol resins, and polyethylene oxide.

Given as examples of the arginic acid derivatives for component (B) are metal salts of arginic acid, such as sodium arginate, potassium arginate, aluminum arginate, calcium arginate, barium arginate, copper arginate, iron arginate, and zinc arginate; arginic acid amine derivatives, such as arginic acid amine and arginic acid triethanol amine; and arginic acid ester derivatives, such as ethylene glycol arginate and propylene glycol arginate. Of these, sodium arginate is particularly preferred.

The aqueous dispersion of a polymer (A) has a minimum film-forming temperature of 10°C or less. The aqueous composition prepared by mixing an aqueous dispersion of the polymer, as a major component, and the water-soluble polymer (B) is preferable. The degree of swelling of the dry film of the resulting aqueous composition is preferably in the range of 0.1-1.5 in water at 20°C. In addition, the present invention provides a sandblast resist ink suitable for use in screen printing which comprises the aqueous composition containing an ink component.

The minimum film-forming temperature in the present invention is determined according to the film-forming temperature determination method described in 4.9 section of JIS K-6826, entitled "vinyl acetate resin emulsion test method".

The minimum film-forming temperature of aqueous dispersion of a polymer (A) used in the present invention can be adjusted by the following methods. For example, in case of polyvinyl acetate polymer, the minimum film-forming temperature can be adjusted after emulsion polymerization by using a protective colloid of a polyvinyl alcohol resin or by using a surfactant, and by adding a plasticizer such as dibutyl phthalate, dioctyl phthalate, dimethyl glycol sebacate, or dimethyl glycol phthalate.

Movinyl 116, Movinyl 303, Movinyl 500 (trademarks, manufactured by Hoechst Synthetic Co.), Polysole S-5S, Polysole NS-2150, Polysole LX-105 (trademarks, manufactured by Showa Polymer Co.), and Toabond #1005, Toabond #6000, Toabond XB-6S, and Toabond XB-2131 (trademarks, manufactured by Toa Paint Co.) are given as examples of such polyvinyl acetate polymers.

In case of ethylene-vinyl acetate copolymer, the minimum film-forming temperature can be adjusted by adjusting the content of ethylene. The ethylene content in the range of 5% to 30% by weight is preferable. Movinyl 084E, Movinyl 180E, Movinyl 123E, Movinyl 191E (trademarks, manufactured by Hoechst Synthetic Co.), Everdic SFC-80, Everdic EV-15, Everdic EV-260 (trademarks, manufactured by Dainippon Ink & Chemicals, Inc.), Vinysole 420, Vinysole 1412 (trademarks, manufactured by Daido Chemical Industries, Ltd.), and Polysole EVA P-3, Polysole EVA AD-2, Polysole EVA L-503, Polysole AD-400, and Polysole EVA P-5E (trademarks, manufactured by Showa Polymer Co.) can be given as examples of such emulsions.

In case of vinyl acetate-acrylate copolymers, such emulsions can be obtained by the copolymerization of vinyl acetate and an acrylate, such as ethyl acrylate, butyl acrylate, or 2-ethylhexyl acrylate. Included in the examples of such emulsions are Movinyl 630, Movinyl DM-5P, Movinyl DS-5 (trademarks, manufactured by Hoechst Synthetic Co.), Polysole HR-8E, Polysole HR-TGL, Polysole PS-120, Polysole L-714 (trademarks, manufactured by Showa Polymer Co.), Resin 125-1140, Resin 125-3850, Yodosole LD-4253, and X-Link 125-2899 (trademarks, manufactured by Kanebo NNC Co.).

Acrylic copolymers can be obtained by the copolymerization of different kinds of acrylates, such as methyl acrylate, ethyl acrylate, and octyl acrylate, or by the copolymerization of an acrylate and styrene, vinyl chloride or the like. Included in the examples of such emulsions are Nikasole RX-284S, Nikasole RX-669A, Nikasole KE-1078 (trademarks, manufactured by Nippon Carbide Indutries, Ltd.), Boncoat ER-405, Boncoat EC-706, Boncoat 4001 (trademarks, manufactured by Dainippon Ink & Chemicals, Inc.), Primal AC-32, Primal AC-61, Primal B-41, Primal HA-24, Primal C-72 (trademarks, manufactured by Nippon Acryl, Co.), Acronal 4D, Acronal 81DN, Acronal YJ-1650D, and Acronal YJ-8400D (trademarks, manufactured by Mitubishi Petrochemical Badish Co.).

Polyurethane polymers can be obtained by the reaction of a polyisocyanate compound, such as 4,4'-diphenylmethane diisocyante, 2,4-tolylene diisocyante, or hexamethylene diisocyante, and a polyol, such as polybutylene adipate, polyethylenebutylene adipate, polycaprolactone, or polyoxytetramethylene glycol. Sunprene UX-1120A, Sunprene UXA (trademarks, manufactured by Sanyo Chemical Indutries, Ltd.), Superflex 190, Superflex 300, Superflex 460, Superflex 750, Superflex E-2000, Superflex E-4500 (trademarks, manufactured by Dai-ichi Kogyo Seiyaku Co.), and Rikabond BA-26N and Rikabond AR-51H (trademarks, manufactured by Chuo Rika Indutries, Ltd.) are given as examples.

The minimum film-forming temperature of component (A) can be adjusted as described above. Component (A) thus may be suitably selected from various types of commercially available aqueous dispersion of the polymer, and may be in the form of emulsion obtained by the emulsion polymerization of monomers, or in the form of dispersion or colloidal dispersion obtained by the mechanical emulsification of polymeric compounds. These aqueous dispersion of the polymer can be used either alone or in combination of two or more. The combination can be selected from the composition exhibiting good adhesion to the materials to be processed.

The water-soluble polymer (B), the other component of the composition of the present invention, is one or more polymers selected from the group consisting of arginic acid derivatives, sodium carboxymethyl cellulose, methylcellulose, polyvinyl alcohol resins, and polyethylene oxide.

The arginic acid derivatives used here include metal salts of arginic acid, such as sodium arginate, potassium arginate, aluminum arginate, calcium arginate, barium arginate, copper arginate, iron arginate, and zinc arginate; arginic acid amine derivatives, such as arginic acid amine and arginic acid triethanol amine; and arginic acid ester derivatives, such as ethylene glycol arginate and propylene glycol arginate.

The polymers are water-soluble, and the purposes of adding these to the composition of the present invention are to provide viscosity during producing resist masks, to improve film-forming property of the composition, to improve dispersant property of the composition in water, to promote adhesion to the materials to be processed, and to facilitate removal of the resist mask.

The resist ink of the present invention produced from the above-mentioned composition is an aqueous composition. It can disperse well in water, but the mask formed is dried to form a film which is insoluble in water. However, because the film contains a water-soluble polymer which is easily water-swellable, the resist mask can be easily removed.

Furthermore, the present invention has the additional advantages that the resist mask which is removed from the surface of materials by water can be easily collected by filters or the like without disposing it in waste water because the mask remains in form of a film.

In order to sufficiently exhibit the aforementioned characteristics of the composition of the present invention, the resist ink should be adjusted so as to produce dry film whose degree of swelling is in the range of 0.1-1.5, preferably 0.2-1.3, in water at 20°C. If the degree of swelling in water is smaller than 0.1, it is difficult to remove the resist mask from the material to be processed. If it is larger than 1.5, the resist mask can be easily removed from the material to be processed. However, with such a high degree of swelling resist mask swelled with water does not possess strength sufficient enough to hold the shape of the film. The resist mask is therefore finely dispersed in water, thereby making it difficult to recover it from waste water.

For determining the degree of swelling, the film of the resist ink is dried at room temperature and immersed in water at 20°C for 48 hours. Water attached to the film is removed with filter paper and the weight of resist ink (W1) is measured. After drying at 105°C for 2 hours, the weight of dried resist ink (W2) is measured. The degree of swelling is determined by the formula (W1-W2)/W2.

The sandblast resist ink of the present invention is effective when used for the screen printing method wherein a resist mask is produced by applying the resist ink by screen printing directly to the surface of the material to be processed or by transferring and attaching a mask, which has been printed on a releasable substrate by screen printing, to the surface to be processed. Water functions as the adhesive for transferring and attaching the mask. Simply applying water to the surface of the material to be processed and pressing the mask thereonto makes the mask swell with water and adhere to the surface. After drying the mask as attached, it exhibits strong adhesion to the surface.

Besides screen printing, various method of printing, such as pad printing, writing or coating with brush, spray coating, and roll coating, are applicable. Because the resist ink of the present invention exhibits sufficient adhesiveness and excellent property by drying at room temperature, it is not essential to dry by heating. Of course, drying with hot air is useful for promoting the efficiency.

Besides, various components may be optionally added, if required, to the composition. The other-components include viscosity adjusting agents (e.g. thickeners, thixotropic agents), leveling agents, defoaming agents, pigments, dyes, and the like.

The sandblast resist ink of the present invention, which is an aqueous composition comprising the aqueous dispersion of the polymer having a minimum film-forming temperature of 10°C or less and the specific water-soluble polymer, can be prepared from an aqueous composition which forms a dry film whose degree of swelling is in the range of 0.1-1.5 by using only water without any organic solvents or surfactants and produces resist mask exhibiting sufficient adhesion to the materials to be processed and has superior sandblasting properties. Because of this, it does not impair working conditions and can eliminate secondary treating steps such as a heating step and a photo-curing step.

Furthermore, the dry resist mask is water-swelled and easily removed from the materials to be processed. Because the mask is in the form of film, the mask removed by water can be recovered by filters such as wire-screen and is not discharged in waste water.

Other features of the invention will become apparent in the course of the following description of the examples. It is understood that these are given for illustration of the invention and are not intended to be limiting thereof.

In the Examples, "parts by weight" and "% by weight" are simply indicated as "parts" and "%", respectively.

### EXAMPLES

### Example 1

100 parts of polyvinyl acetate emulsion (Movinyl 116, manufactured by Hoechst Synthetic Co., solid content: 50%, minimum film-forming temperature: 0°C) and 50 parts of 20% aqueous solution of partially saponified PVA (PA-05, trademark, manufactured by Shin-etsu Chemical Co.) were mixed. 15 parts of 20% aqueous solution of sodium arginate (manufactured by Kimitsu Chemical Co.) and 1 part of a blue pigment (Emacoal Blue HB, trademark, manufactured by Sanyo Shikiso Industry, Ltd.) were added to the mixture, and the resulting mixture was blended.

The degree of swelling of the resist ink obtained was 0.8 at 20°C in water. An image of 2 mm pitch was formed on a 250 mesh screen of Tetron (trademark) fabric with a 30 µm thickness and printed on a glass plate using the resist ink obtained. The resist ink was dried at room temperature to obtain a resist mask with a dry thickness of 30 µm on the glass plate. Sandblasting was performed with injecting emery #120 at air pressure of 3 kg/cm² from a distance of 20 cm for 2 minutes. The resist mask was loosened and removed from the plate when tap water was poured onto the glass plate for 1 minute.

The glass plate was engraved to a depth of 1 mm at a width of 1 mm, with no problems related to adhesion sandblast resistance of the mask. The screen and squeegee were completely cleaned by washing with water. The resist mask removed from the glass plate was collected using 20 mesh wire-screen.

### Example 2

100 parts of ethylene-vinyl acetate copolymer emulsion (Polysole EVA-P4, trademark, manufactured by Showa Polymer Co., solid content: 50%, minimum film-forming temperature: 0°C) and 20 parts of 20% aqueous solution of triethanolamine arginate (manufactured by Kimitsu Chemical Co.) were mixed and stirred. 0.3 part of a defoaming agent (Acarene SB-510, trademark, manufactured by Kyoeisha Yushi Co.) and 1 part of a blue pigment (Emacoal Blue HB, trademark, manufactured by Sanyo Shikiso Industry, Ltd.) were added to the mixture, and the resulting mixture was blended.

The degree of swelling of the resist ink obtained was 0.7 at 20°C in water. An image of a 3 mm pitch was produced on a 200 mesh screen of Tetron fabric with a thickness of 30 µm and printed on an acryl resin plate using the resist ink.

The resist ink was dried at room temperature to obtain a resist mask with a dry thickness of 20 µm on the acryl resin plate. Sandblasting was performed with emery #180 at air pressure of 3 kg/cm² from a distance of 20 cm for 3 minutes.

The resist mask was loosened and removed from the plate when tap water was poured onto the acryl resin plate for 40 seconds. The acryl resin plate was engraved to a depth of 0.2 mm at a width of 1.5 mm, with no problems related to the adhesion or sandblast resistance of the mask. The screen and squeegee were completely cleaned by washing with water. The resist mask removed from the acryl resin plate was collected using 20 mesh wire-screen.

### Example 3

150 parts of acrylic copolymer emulsion (Movinyl 700, manufactured by Hoechst Synthetic Co., solid content: 47%, minimum film-forming temperature: 5°C) and 35 parts of 20% aqueous solution of propylene glycol arginate (manufactured by Kimitsu Chemical Co.) were mixed. 0.2 part of a defoaming agent (SN Defoamer 485, trademark, manufactured by Sunnopuko Co.) and 1.5 part of a blue pigment (Emacoal Blue HB, tardemark, manufactured by Sanyo Shikiso Industry, Ltd.) were added to the mixture, and the resulting mixture was blended.

The degree of swelling of the resist ink obtained was 0.9 at 20°C in water. An image of 1 mm pitch was produced on a 250 mesh screen of Tetron fabric with a 30 µm thickness and printed on a stainless steel plate using the resist ink.

The resist ink was dried at room temperature to obtain a resist mask with a thickness of 30 µm on the stainless steel plate. Sandblasting was performed with emery #400 at air pressure of 3 kg/cm² from a distance of 20 cm for 3 minutes.

The resist mask was loosened and removed from the plate when tap water was poured onto the stainless steel plate for 30 seconds. The stainless steel plate was engraved to a depth of 0.2 mm at a width of 0.5 mm, with no problems related to adhesion or sandblast resistance of the mask. The screen and squeegee were completely cleaned by washing with water. The resist mask removed from the stainless steel plate was collected using 20 mesh wire-screen.

### Example 4

100 parts of ethylene-vinyl acetate copolymer emulsion (EV-260: trademark, manufactured by Dainippon Ink & Chemicals, Inc., solid content: 50%, minimum film-forming temperature: 7°C), 30 parts of 15% aqueous solution of methylcellulose (Metlose 60SH-100, trademark, manufactured by Shin-etsu Chemical Co.), and 10 parts of polyvinyl methyl ether (Rutonal 40, trademark, manufactured by BAS Co., 50% aqueous solution) were mixed. Then, 0.1 part of a defoaming agent (SN Defoamer 485, trademark, manufactured by Sunnopuko Co.), 1 part of a blue pigment (Emacoal Blue HB, tardemark, manufactured by Sanyo Shikiso Industry, Ltd.), and 10 parts of water were added to the mixture, and the resulting mixture was blended.

The degree of swelling of the resist ink obtained was 0.4 at 20°C in water. An image of 3 mm pitch was produced on a 200 mesh screen of Tetron fabric with a 30 µm thickness and printed on an acryl resin plate using the resist ink.

The resist ink was dried at room temperature to obtain a resist mask with a thickness of 25 µm on the acryl resin plate. Sandblasting was performed with emery #180 at air pressure of 4 kg/cm² from a distance of 20 cm for 3 minutes.

The resist mask was loosened and removed from the plate when tap water was poured onto the acryl resin plate for 30 seconds. The acryl resin plate was engraved to a depth of 0.2 mm at a width of 1.5 mm, with no problems related to adhesion or sandblast resistance of the mask. The screen and squeegee were completely cleaned by washing with water. The resist mask removed from the acryl resin plate was collected using 20 mesh wire-screen.

### Example 5

150 parts of vinyl acetate-acrylate copolymer emulsion (Polysole HR-TGL: trademark, manufactured by Showa Polymer Co., solid content: 41%, minimum film-forming temperature: 8°C), 40 parts of 10% aqueous solution of alkylated polyvinyl alcohol (COT P-1000, trademark, manufactured by Shin-etsu Chemical Co.) and, as a viscosity adjusting agent, 20 parts of an acrylic acid polymer (Jullymer AC-20L, trademark, manufactured by Nihon Junyaku Co., 40% aqueous solution) were mixed. Then, 0.1 part of a defoaming agent (SN Defoamer 485, trademark, manufactured by Sunnopuko Co.) and 2 parts of a blue pigment (Emacoal Blue HB, trademark, manufactured by Sanyo Shikiso Industry, Ltd.) were added to the mixture, and the resulting mixture was blended.

The degree of swelling of the resist ink obtained was 0.9 at 20°C in water. A picture was drawn on a glass cup with a paint brush using this resist ink. There were irregularities in the thickness of the mask obtained after drying, which reflected uneven attachment of the resist ink by the paint brush. Sandblasting was performed with emery #180 at air pressure of 3 kg/cm² from a distance of 20 cm for 2 minutes.

The resist mask was loosened and removed from the glass when tap water was poured onto the glass cup for 30 seconds. There were no problems related to adhesion or sandblast resistance of the mask. The picture obtained on the glass well reproduced the touch of the paint brush. The paint brush was cleaned by washing with water. The resist mask removed from the surface of the glass was collected using 20 mesh wire-screen.

### Example 6

80 parts of acrylic copolymer emulsion (Nikasole RX-284S: trademark, manufactured by Nippon Carbide Industries, Ltd., solid content: 38%, minimum film-forming temperature: 0°C), 40 parts of vinyl acetate-acrylate copolymer emulsion (Resin 125-1140: trademark, manufactured by Kanebo NNC Co., solid content: 50%, minimum film-forming temperature: 0°C), 50 parts of 10% aqueous solution of polyethylene oxide (PEG 20000: trademark, manufactured by Sanyo Chemical Industries, Ltd), and 10 parts of a viscosity adjusting agent (SN Thickener 612, solid content: 40%, trademark, manufactured by Sunnopuko Co.) were mixed. Then, 0.5 part of a defoaming agent (Acarene SB-510, trademark, manufactured by Kyoeisha Yushi Co.) and 2 parts of a blue pigment (Emacoal Blue HB, trademark, manufactured by Sanyo Shikiso Industry, Ltd.) were added to the mixture, and the resulting mixture was blended. The degree of swelling of the resist ink obtained was 0.3 at 20°C in water.

This resist ink was transferred by screen printing (a 150 mesh screen of Tetron fabric was provided with an image of a 5 mm pitch with a thickness of 60 µm) on a polyester film, the surface of which was treated to have a peeling strength of 10-30 gf/50 mm in a dry state. A resist mask with a thickness of 60 µm was thus produced.

The resist mask was then attached to the surface of a glass plate, lightly wet with water, by pressing with a rubber roller from the end. The polyester film was removed and the resist mask was dried. The resist mask was completely transferred to the glass plate in this manner.

After drying, sandblasting was performed with emery #100 at air pressure of 3 kg/cm² from a distance of 15 cm for 2 minutes.

The resist mask was loosened and removed from the plate when tap water was poured onto the glass plate for 1 minute. The glass plate was engraved to a depth of 2 mm, with no problems related to the adhesion or blast resistance of the mask. The screen and squeegee were completely cleaned by washing with water. The resist mask removed from the glass plate was collected using 20 mesh wire-screen.

### Example 7

90 parts of a polyurethane resin dispersion (Superflex E-4500: trademark, manufactured by Dai-ichi Kogyo Seiyaku Co., solid content: 45%, minimum film-forming temperature: 0°C), 100 parts of 3% aqueous solution of sodium carboxymethyl cellulose (Serogen EP: trademark, manufactured by Dai-ichi Kogyo Seiyaku Co.), and 20 parts of a thickener (SN Thickener 612, solid content: 40%, trademark, manufactured by Sunnopuko Co.) were mixed. Then, 3 parts of a white pigment (Sandai Super White: trademark, manufactured by Sanyo Shikiso Industry, Ltd.), 0.5 part of leveling agent (Daiflon, DS-102, trademark, manufactured by Daikin Industries, Ltd.), and 0.5 part of a defoaming agent (SN Defoamer 483, trademark, manufactured by Sunnopuko Co.) were added to the mixture, and the resulting mixture was blended.

The degree of swelling of the resist ink obtained was 1.1 at 20°C in water. An image of 1 mm pitch was produced on a 250 mesh screen of Tetron fabric screen with a 50 µm thickness and printed on a specularly polished stainless steel plate using the resist ink.

The resist ink was dried at room temperature to obtain a resist mask with a thickness of 40 µm on the stainless steel plate. Sandblasting was performed with emery #400 at air pressure of 4 kg/cm² from a distance of 20 cm for 3 minutes.

The resist mask was loosened and removed from the plate when tap water was poured onto the stainless steel plate for 20 seconds. The stainless steel plate was engraved to a depth of 0.2 mm for a width of 0.5 mm, with no problems related to adhesion or sandblast resistance of the mask. The screen and squeegee were completely cleaned by washing with water. The resist mask removed from the stainless steel plate was collected using 20 mesh wire-screen.

### Example 8

50 parts of polyvinyl acetate resin emulsion (Toabond #6000: trademark, manufactured by Toa Paint Co., solid content: 42%, minimum film-forming temperature: 3°C), 100 parts of a polyurethane resin dispersion (Superflex E-4500: trademark, manufactured by Dai-ichi Kogyo Seiyaku Co., solid content: 45%, minimum film-forming temperature: 0°C), and 65 parts of 10% aqueous solution of alkylated polyvinyl alcohol (COT P-2000, trademark, manufactured by Shin-etsu Chemical Co.) were mixed. Then, 0.1 part of a leveling agent (Phthargent 250, trademark, manufactured by Neos Co.), 0.5 part of a defoaming agent (SN Defoamer 483, trademark, manufactured by Sunnopuko Co.), and 2 parts of a blue pigment (Emacoal Blue HB, trademark, manufactured by Sanyo Shikiso Industry, Ltd.) were added to the mixture, and the resulting mixture was blended.

The degree of swelling of the resist ink obtained was 0.6 at 20°C in water.

Printing, drying, and sandblasting were carried out using this resist ink in the same manner as in Example 1. As a result, sandblasting was carried out with no problems related to adhesion or blast resistance of the mask. The mask could be removed using water. The screen and squeegee were completely cleaned by washing with water. The resist mask removed from the stainless steel plate was collected using 20 mesh wire-gauze.

### Comparative Example 1

A resist ink was prepared in the same manner as in Example 1 using polyvinyl acetate emulsion (Movinyl 350: trademark, manufactured by Hoechst Synthetic Co., content: 45%, minimum film-forming temperature: 18°C) instead of the polyvinyl acetate emulsion of Example 1. The degree of swelling of the resist ink obtained was 0.6 at 20°C in water. The resist ink was evaluated in the same manner as in Example 1. As a result, the mask blew off during sandblasting and could not form a line with a width of 1 mm.

### Comparative Example 2

A resist ink was prepared in the same manner as in Example 3 using a vinyl acetate-acrylate copolymer emulsion (Polysole AT-1000: trademark, manufactured by Showa Polymer Co., solid content: 50%, minimum film-forming temperature: 45°C) instead of the vinyl acetate-acrylate copolymer emulsion of Example 3. When the dry film of the resist ink was immersed in water to measure the degree of swelling at 20°C, it was finely dispersed in water because it didn't form a real firm film.

### Comparative Example 3

A resist ink was prepared from the same materials and in the same manner as in Example 1, except that the comparative amounts of the polyvinyl acetate emulsion, 20% aqueous solution of partially saponified PVA, and 20% aqueous solution of sodium arginate was changed to 100 parts, 60 parts, and 30 parts, respectively.

The degree of swelling of the resist ink obtained was 1.9 at 20°C in water. By using this resist ink a glass plate was processed by sandblasting in the same manner as in Example 1. The resist mask was loosened and removed from the plate when tap water was poured onto the glass plate for 30 seconds. The glass plate was engraved to a depth of 1 mm of a width of 1 mm, with no problems related to adhesion or sandblast resistance of the mask. The screen and squeegee were completely cleaned by washing with water. However, the resist mask removed from the glass plate passed through 20 mesh wire-screen and could not be recovered.

As a result, the object of the present invention was not to be achieved if the degree of swelling in water falls outside the scope of the present invention. In this Comparative Example, the degree of swelling of the resist ink was different from that of Example 1 due to the use of the aqueous dispersible polymer (A) and the water-soluble polymer (B) at a different ratio.

### Comparative Example 4

A resist ink was prepared in the same manner as in Example 1, except that partially saponified PVA and sodium arginate were not used and 200 parts of polyvinyl acetate emulsion was used. The degree of swelling of the resist ink obtained was 0.05 at 20°C in water.

The resist ink was evaluated in the same manner as in Example 1. As a result, it was found that even though there were no problems related to adhesion or blast resistance of the mask, the ink attached to the screen could not be washed out with water and the resist mask could not be removed when tap water was poured onto the glass plate for 5 minutes.

Obviously, numerous modifications and variations of the present invention are possible in light of the above teachings. It is therefore to be understood that within the scope of the appended claims, the invention may be practiced otherwise than as specifically described herein.

## Claims

1. A sandblast resist ink which is an aqueous composition **characterized in that** it comprises (A) an aqueous dispersion of a polymer having a minimum film-forming temperature of 10°C or lower and (B) a water-soluble polymer as a film-forming auxiliary agent.

2. The sandblast resist ink according to claim 1, wherein component (A) is the major component and component (B) is a subsidiary component.

3. The sandblast resist ink according to claim 1, wherein a dry film produced by the aqueous composition has a degree of swelling in the range of 0.1-1.5 in water at 20°C.

4. The sandblast resist ink according to claim 1, wherein said aqueous dispersible polymer (A) is at least one aqueous dispersion of the polymer selected from the group consisting of polyvinyl acetate resins, ethylene-vinyl acetate copolymers, vinyl acetate-acrylate copolymers, acrylic copolymers, and polyurethane copolymers.

5. The sandblast resist ink according to claim 1, wherein said water-soluble polymer (B) as film-forming auxiliary agent is at least one water-soluble polymer selected from the group consisting of arginic acid derivatives, sodium carboxymethyl cellulose, methylcellulose, polyvinyl alcohol resins, and polyethylene oxide.

6. The sandblast resist ink according to claim 5, wherein said arginic acid derivative is selected from the group consisting of (1) metal salts of arginic acid, such as sodium arginate, potassium arginate, aluminum arginate, calcium arginate, barium arginate, copper arginate, iron arginate, and zinc arginate; (2) arginic acid amine derivatives, such as arginic acid amine and arginic acid triethanol amine; and (3) arginic acid ester derivatives, such as ethylene glycol arginate and propylene glycol arginate.

7. The sandblast resist ink according to claim 6, wherein said arginic acid derivative is sodium arginate.

8. In a method for sandblast to produce relief of photographic images, patterns, letters, or characters on the surface of materials to be processed, a method **characterized by** using a sandblast resist ink which is an aqueous composition comprising (A) an aqueous dispersion of a polymer having a minimum film-forming temperature at 10°C or lower and (B) a water-soluble polymer as a film-forming auxiliary agent.

9. The method according to claim 8, wherein said material to be processed is glass, stone, ceramic, metal, plastics, or wood.

10. The method according to claim 8, wherein component (A) is the major component and component (B) is a subsidiary component.

11. The method according to claim 8, wherein a dry film produced from the aqueous composition has a degree of swelling in the range of 0.1-1.5 in water at 20°C.

12. The method according to claim 8, wherein said aqueous dispersion comprising at least one aqueous dispersion of the polymer (A) selected from the group consisting of polyvinyl acetate resins, ethylene-vinyl acetate copolymers, vinyl acetate-acrylate copolymers, acrylic copolymers, and polyurethane copolymers.

13. The method according to claim 8, wherein said water-soluble polymer comprising at least one water-soluble polymer (B) selected from the group consisting of arginic acid derivatives, sodium carboxymethyl cellulose, methylcellulose, polyvinyl alcohol resins, and polyethylene oxide.

14. The method according to claim 13, wherein said arginic acid derivative is selected from the group consisting of (1) metal salts of arginic acid, such as sodium arginate, potassium arginate, aluminum arginate, calcium arginate, barium arginate, copper arginate, iron arginate, and zinc arginate; (2) arginic acid amine derivatives, such as arginic acid amine and arginic acid triethanol amine; and (3) arginic acid ester derivatives, such as ethylene glycol arginate and propylene glycol arginate.

15. The method according to claim 14, wherein said arginic acid derivative is sodium arginate.

## Patentansprüche

1. Sandstrahlen-beständige Tinte, welche eine wäßrige Zusammensetzung ist,
**dadurch gekennzeichnet, dass** sie (A) eine wäßrige Dispersion eines Polymers mit einer minimalen filmbildenden Temperatur von 10°C oder darunter und (B) ein wasserlösliches Polymer als einen filmbildenden Zusatzstoff umfasst.

2. Sandstrahlen-beständige Tinte nach Anspruch 1, bei welcher Komponente (A) die Hauptkomponente und Komponente (B) eine Unterkomponente ist.

3. Sandstrahlen-beständige Tinte nach Anspruch 1, bei welcher ein durch die wäßrige Zusammensetzung erzeugter Trockenfilm einen Schwellgrad im Bereich von 0,1-1,5 in Wasser bei 20°C aufweist.

4. Sandstrahlen-beständige Tinte nach Anspruch 1, bei welcher das wäßrige dispersible Polymer (A) wenigstens eine wäßrige Dispersion des Polymers ist, welches aus der der Gruppe bestehend aus Polyvinylacetat-Harzen, Ethylenvinylacetat-Kopolymeren, Vinylacetat-Acrylat-Kopolymeren, Acryl-Kopolymeren und Polyurethan-Kopolymeren, gewählt ist.

5. Sandstrahlen-beständige Tinte nach Anspruch 1, bei welcher das wasserlösliche Polymer (B) als filmbildender Zusatzstoff wenigstens ein wasserlösliches Polymer, gewählt aus der Gruppe bestehend aus Argininsäure-Derivaten, Natriumcarboxymethylzellulose, Methylzellulose, Polyvinylalkohol-Harzen und Polyethylenoxid, ist.

6. Sandstrahlen-beständige Tinte nach Anspruch 5, bei welcher das Argininsäure-Derivat aus der Gruppe bestehend aus (1) Metallsalzen der Argininsäure, wie Natriumarginat, Kaliumarginat, Aluminiumarginat, Kalziumarginat, Bariumarginat, Kupferarginat, Eisenarginat und Zinkarginat; (2) Argininsäureamin-Derivaten, wie Argininsäureamin und Argininsäuretriethanolamin; und (3) Argininsäureester-Derivaten, wie Ethylenglykolarginat und Propylenglykolarginat gewählt ist.

7. Sandstrahlen-beständige Tinte nach Anspruch 6, bei welcher das Argininsäure-Derivat Natriumarginat ist.

8. Sandstrahl-Verfahren zum Erzeugen eines Reliefs aus photographischen Bildern, Mustern, Buchstaben oder Zeichen auf der Oberfläche von zu bearbeitenden Materialien, welches Verfahren **dadurch gekennzeichnet ist, dass** eine Sandstrahlen-beständige Tinte verwendet wird, welche eine wäßrige Zusammensetzung ist, die (A) eine wäßrige Dispersion eines Polymers mit einer minimalen filmbildenden Temperatur von 10°C oder darunter und (B) ein wasserlösliches Polymer als einen filmbildenden Zusatzstoff umfasst.

9. Verfahren nach Anspruch 8, bei welchem das zu bearbeitende Material Glas, Stein, Keramik, Metall, Plastik oder Holz ist.

10. Verfahren nach Anspruch 8, bei welchem Komponente (A) die Hauptkomponente und Komponente (B) eine Unterkomponente ist.

11. Verfahren nach Anspruch 8, bei welchem ein durch die wäßrige Zusammensetzung erzeugter Trockenfilm einen Schwellgrad im Bereich von 0,1-1,5 in Wasser bei 20°C aufweist.

12. Verfahren nach Anspruch 8, bei welchem die wäßrige Dispersion wenigstens eine wäßrige Dispersion des Polymers (A), gewählt aus der Gruppe bestehend aus Polyvinylacetat-Harzen, Ethylenvinylacetat-Kopolymeren, Vinylacetat-Acrylat-Kopolymeren, Acryl-Kopolymeren und Polyurethan-Kopolymeren, umfasst.

13. Verfahren nach Anspruch 8, bei welchem das wasserlösliche Polymer wenigstens ein wasserlösliches Polymer(B), gewählt aus der Gruppe bestehend aus Argininsäure-Derivaten, Natriumcarboxymethylzellulose, Methylzellulose, Polyvinylalkohol-Harzen und Polyethylenoxid, umfasst.

14. Verfahren nach Anspruch 13, bei welchem das Argininsäure-Derivat aus der Gruppe bestehend aus (1) Metallsalzen der Argininsäure, wie Natriumarginat, Kaliumarginat, Aluminiumarginat, Kalziumarginat, Bariumarginat, Kupferarginat, Eisenarginat und Zinkarginat; (2) Argininsäureamin-Derivaten, wie Argininsäureamin und Argininsäuretriethanolamin; und (3) Argininsäureester-Derivaten, wie Ethylenglykolarginat und Propylenglykolarginat gewählt ist.

15. Verfahren nach Anspruch 14, bei welchem das Argininsäure-Derivat Natriumarginat ist.

## Revendications

1. Encre résistant au sablage qui est une composition aqueuse **caractérisée en ce qu'**elle comprend (A) une dispersion aqueuse d'un polymère possédant une température filmogène minimale de 10°C ou inférieure et (B) un polymère hydrosoluble en tant qu'agent auxiliaire filmogène.

2. Encre résistant au sablage selon la revendication 1, dans laquelle le composant (A) est le composant principal et le composant (B) est un composant facultatif.

3. Encre résistant au sablage selon la revendication 1, dans laquelle un film sec produit par la composition aqueuse possède un degré de gonflement, dans l'eau, dans la gamme de 0,1 à 1,5 à 20°C.

4. Encre résistant au sablage selon la revendication 1, dans laquelle le polymère hydrodispersible (A) est au moins une dispersion aqueuse du polymère choisi dans le groupe formé par les résines poly(acétate de vinyle), les copolymères éthylène/acétate de vinyle, les copolymères acétate de vinyle/acrylate, les copolymères acryliques, et les copolymères de polyuréthanne.

5. Encre résistant au sablage selon la revendication 1, dans laquelle ledit polymère hydrosoluble (B) en tant qu'agent auxiliaire filmogène est au moins un polymère hydrosoluble choisi dans le groupe formé par les dérivés d'acide arginique, la carboxyméthylcellulose sodique, la méthylcellulose, les résines poly(alcool vinylique), et le poly(oxyde d'éthylène).

6. Encre résistant au sablage selon la revendication 5, dans laquelle ledit dérivé d'acide arginique est choisi dans le groupe formé par (1) les sels métalliques de l'acide arginique, tels que l'arginate de sodium, l'arginate de potassium, l'arginate d'aluminium, l'arginate de calcium, l'arginate de baryum, l'arginate de cuivre, l'arginate de fer, et l'arginate de zinc ; (2) les dérivés aminés de l'acide arginique, tels que l'acide aminoarginique et l'acide triéthanolamine-arginique ; et les dérivés ester de l'acide arginique, tels que l'arginate d'éthylèneglycol et l'arginate de propylèneglycol.

7. Encre résist ant au sablage selon la revendication 6, dans laquelle ledit dérivé d'acide arginique est l'arginate de sodium.

8. Procédé **caractérisé par** l'utilisation d'une encre résistant au sablage, dans un procédé de sablage pour produire un relief d'images photographiques, de motifs, de lettres, ou de caractères sur la surface de matériaux à traiter, qui est une composition aqueuse comprenant (A) une dispersion aqueuse d'un polymère possédant une température filmogène minimale à 10°C ou inférieure et (B) un polymère hydrosoluble en tant qu'agent auxiliaire filmogène.

9. Procédé selon la revendication 8, dans lequel ledit matériau à traiter est le verre, la pierre, la céramique, le métal, la matière plastique, ou le bois.

10. Procédé selon la revendication 8, dans lequel le composant (A) est le composant principal et le composant (B) est un composant facultatif.

11. Procédé selon la revendication 8, dans lequel un film sec produit à partir de la composition aqueuse possède un degré de gonflement, dans l'eau, dans la gamme de 0,1 à 1,5 à 20°C.

12. Procédé selon la revendication 8, dans lequel ladite dispersion aqueuse comprenant au moins une dispersion aqueuse du polymère (A) choisi dans le groupe formé par les résines poly(acétate de vinyle), les copolymères éthylène/acétate de vinyle, les copolymères acétate de vinyle/acrylate, les copolymères acryliques, et les copolymères de polyuréthanne.

13. Procédé selon la revendication 8, dans lequel ledit polymère hydrosoluble comprenant au moins un polymère hydrosoluble (B) choisi dans le groupe formé par les dérivés d'acide arginique, la carboxyméthylcellulose sodique, la méthylcellulose, les résines poly(alcool vinylique), et le poly(oxyde d'éthylène).

14. Procédé selon la revendication 13, dans lequel ledit dérivé d'acide arginique est choisi dans le groupe formé par (1) les sels métalliques de l'acide arginique, tels que l'arginate de sodium, l'arginate de potassium, l'arginate d'aluminium, l'arginate de calcium, l'arginate de baryum, l'arginate de cuivre, l'arginate de fer, et l'arginate de zinc ; (2) les dérivés aminés de l'acide arginique, tels que l'acide aminoarginique et l'acide triéthanolamine-arginique ; et (3) les dérivés ester de l'acide arginique, tels que l'arginate d'éthylèneglycol et l'arginate de propylèneglycol.

15. Procédé selon la revendication 14, dans lequel ledit dérivé d'acide arginique est l'arginate de sodium.
